# EUROPÄISCHE PATENTSCHRIFT

(11) **EP 1 758 137 B1**
(45) Veröffentlichungstag und Bekanntmachung des Hinweises auf die Patenterteilung: **09.12.2009**
(21) Anmeldenummer: 06015730.2
(22) Anmeldetag: 28.07.2006
(51) Int. Cl.: H01H 13/00, H03K 17/96

(54) **Schaltereinheit mit Näherungssensor**
Switch unit with a proximity sensor
Unité de commutation avec un capteur de proximité

(30) Priorität: 25.08.2005 DE 102005041039
(43) Veröffentlichungstag der Anmeldung: 28.02.2007
(73) Patentinhaber: Valeo Schalter und Sensoren GmbH, 74321 Bietigheim-Bissingen (DE)
(72) Erfinder: Staude, Sascha, 74321 Bietigheim-Bissingen (DE); Petzold, Manuel, 74321 Bietigheim (DE)
(74) Vertreter: Thielking, Klaus

(56) Entgegenhaltungen:
- EP-B1- 1 290 705
- DE-A1- 10 220 797
- DE-A1- 19 945 538
- DE-A1-102004 026 836

## Beschreibung

Die Erfindung betrifft eine Schaltereinheit mit einem durch Bewegung betätigbaren Betätigungselement, wobei dem Betätigungselement ein elektrisch kontaktierter Näherungssensor zugeordnet ist. Die Näherungssensoren solcher Schaltereinheiten können auf einem kapazitiven oder einem induktiven Prinzip beruhen. Kapazitive Näherungssensoren können Kondensatoren aufweisen, deren Kapazität sich bei Annäherung oder Berührung des Sensors ändert, wobei die Änderung mit Hilfe einer Auswerteeinheit erfasst werden kann. Bei induktiven Näherungssensoren wird von einem Oszillator ein hochfrequentes elektromagnetisches Wechselfeld erzeugt. Dringt ein Objekt in dieses Wechselfeld ein, wird die Oszillatorspannung gedämpft, wodurch sich ein entsprechendes Ausgangssignal ändert.

Mit dem Näherungssensor kann eine erste Schaltfunktion verwirklicht werden. Die Schaltereinheit kann beispielsweise in einem Kraftfahrzeug angeordnet sein und durch Näherung oder Berührung des Fingers einer das Kraftfahrzeug lenkenden Person ausgelöst werden. Wenn das Betätigungselement bewegt, also nicht nur berührt wird, kann in herkömmlicher Weise eine zweite Schaltfunktion verwirklicht werden.

Die beschriebenen Schaltereinheiten werden in großen Stückzahlen hergestellt. Deshalb ist es wichtig, die Schaltereinheit möglichst preisgünstig herstellen zu können. Gleichzeitig muss aber eine zuverlässige elektrische Kontaktierung des Näherungssensors gewährleistet sein.

Das Dokument EP 112 90 705 offenbart die Merkmale des Oberbegriffs des Anspruchs 1.

Der vorliegenden Erfindung liegt hiervon ausgehend die Aufgabe zugrunde, eine preisgünstig herstellbare Schaltereinheit zu schaffen, mit der der Näherungssensor zuverlässig elektrisch kontaktiert werden kann.

Diese Aufgabe wird erfindungsgemäß dadurch gelöst, dass die elektrische Kontaktierung des Näherungssensors in einem betätigten Zustand des Betätigungselements unterbrochen und in einem unbetätigten Zustand des Betätigungselements geschlossen ist.

Die Erfindung beruht auf der Idee, dass es bei der mehrstufigen Auslösung der verschiedenen Schaltfunktionen der Schaltereinheit nicht notwendig ist, eine dauerhafte Kontaktierung in allen Bewegungszuständen des Betätigungselements für den Näherungssensor vorzusehen. Die Kontaktierung muss nur dann hergestellt sein, wenn das Betätigungselement sich in einem unbetätigten Zustand befindet. Nähert sich nun ein Objekt, beispielsweise der Finger einer Bedienperson, der Schaltereinheit und somit dem Näherungssensor, kann dieser für den Wechsel eines entsprechenden Ausgangssignals ausgelöst werden, da sich die elektrische Kontaktierung in einem geschlossenen Zustand befindet. Wird das Betätigungselement nun, über die Berührung hinausgehend, aus einer Ruhestellung herausbewegt, kann die herkömmliche Schaltfunktion der Schaltereinheit verwirklicht werden. In diesem Zustand ist es aber nicht notwendig, dass der Näherungssensor elektrisch kontaktiert ist.

Mit der vorliegenden Erfindung ist es möglich, dass zwei relativ zueinander bewegliche Bauteile, also einerseits das Betätigungselement und/oder der Näherungssensor und andererseits ortsfeste Bauteile der Schaltereinheit in zuverlässiger Weise elektrisch miteinander verbunden werden können, wenn dies für die Funktion der Schaltereinheit erforderlich ist. Der Bewegungsweg des Betätigungselements muss somit nicht, beispielsweise unter Verwendung von biegeschlaffen Kabeln, elektrisch überbrückt werden.

Eine vorteilhafte Ausführungsform der Erfindung sieht vor, dass die Schaltereinheit einen Schalter umfasst, der von dem Betätigungselement betätigbar ist und eine Rückstellkraft erzeugt, die die elektrische Kontaktierung schließt und/oder in einem geschlossenen Zustand hält. Ein solcher Schalter kann beispielsweise durch einen Mikroschalter gebildet sein, der durch eine Drückbewegung des Betätigungselements betätigt wird. Durch die Rückstellkraft des Schalters ist in zuverlässiger Weise gewährleistet, dass das Betätigungselement wieder zurück in eine Ausgangsstellung gelangt, in der die elektrische Kontaktierung geschlossen ist. In diesem geschlossenen Zustand der elektrischen Kontaktierung kann wiederum die oben beschriebene Schaltfunktion des Näherungssensors verwirklicht werden.

Der Schalter kann durch eine Hub-, Dreh-, Schiebe- und/oder Kippbewegung des Betätigungselements betätigbar sein.

Nach einer weiteren Ausführungsform der Erfindung ist das Betätigungselement durch Betätigung elastisch verformbar und erzeugt eine Rückstellkraft, die die elektrische Kontaktierung schließt und/oder in einem geschlossenen Zustand hält. Das Betätigungselement kann beispielsweise aus einem Kunststoffmaterial gebildet sein und geringfügig unter Vorspannung stehen, so dass die elektrische Kontaktierung geschlossen werden kann. Diese Rückstellkraft kann alternativ oder parallel zu einer Rückstellkraft erzeugt werden, der durch den oben beschriebenen Schalter erzeugt wird.

In entsprechender Weise kann die Rückstellkraft kumulativ oder optional zu den vorgenannten Maßnahmen dadurch erzeugt werden, dass die Schaltereinheit ein separates, insbesondere als Feder ausgebildetes, elastisches Element umfasst. Mit einem solchen Element kann eine genau definierte Rückstellkraft erzeugt werden, da dieses Element ausschließlich im Hinblick auf diese Funktion konstruiert sein kann, beispielsweise als Feder mit entsprechender Länge und Federkonstante.

Wenn die elektrische Kontaktierung einen Kontaktbereich aufweist, der dem Betätigungselement zugeordnet ist und einen relativ zu dem Betätigungselement ortsfesten Kontaktbereich, kann eine elektrische Kontaktierung geschaffen werden, die sehr einfach aufgebaut und somit sehr zuverlässig ist. Im geschlossenen Zustand der elektrischen Kontaktierung liegen die Kontaktbereiche aneinander an, so dass der Näherungssensor betätigt werden kann; im betätigten Zustand des Betätigungselements sind die Kontaktbereiche voneinander beabstandet.

Der dem Betätigungselement zugeordnete Kontaktbereich kann elektrisch mit dem Näherungssensor verbunden und/oder einstückig mit diesem ausgebildet sein. Bei einstückiger Ausbildung des Näherungssensors und des Kontaktbereichs wird der Herstellungs- und Montageaufwand auf ein Minimum reduziert.

Der ortsfeste Kontaktbereich kann elektrisch mit einer Auswerteeinheit für den Näherungssensor und/oder mit einer Platine der Schaltereinheit verbunden sein. Der ortsfeste Kontaktbereich muss also nicht direkt an der Auswerteeinheit für den Näherungssensor oder einer Platine der Schaltereinheit vorgesehen sein, sondern kann, entsprechenden Bauraumbedingungen genügend, räumlich entfernt von diesen Bauteilen vorgesehen sein.

Der ortsfeste Kontaktbereich kann beispielsweise an einem Gehäuse der Schaltereinheit angeordnet sein. Solche Gehäuse werden in üblicher Weise aus einem Kunststoffmaterial im Spritzgussverfahren hergestellt, so dass in einfacher Weise Gehäuseabschnitte vorgesehen sein können, die zur Anordnung und/oder Befestigung des ortsfesten Kontaktbereichs dienen.

Das Gehäuse kann auch einen elektrischen Leiter aufweisen, der den ortsfesten Kontaktbereich mit der Auswerteeinheit für den Näherungssensor und/oder mit der Platine der Schaltereinheit elektrisch verbindet. Somit kann das Gehäuse als Träger für ortsfeste elektrische Leiter verwendet werden.

Der ortsfeste Kontaktbereich kann auch an der Platine der Schaltereinheit angeordnet sein. In diesem Fall ist es möglich, den Kontaktbereich des Betätigungselements direkt, also ohne Zwischenschaltung weiterer Bauteile, mit der Auswerteeinheit oder der Platine elektrisch zu kontaktieren, während das Betätigungselement sich in seinem unbetätigten Zustand befindet.

Eine besonders vorteilhafte Ausführungsform der Erfindung sieht vor, dass der Kontaktbereich des Betätigungselements an einem Abschnitt des Betätigungselements angeordnet ist, der den ortsfesten Kontaktbereich hintergreift. Somit wird eine Art Widerlager geschaffen werden, das eine auf das Betätigungselement ausgeübte Rückstellkraft für ein Schließen der elektrischen Kontaktierung aufnimmt.

In vorteilhafter Weise ist der Abschnitt des Betätigungselements, der den ortsfesten Kontaktbereich hintergreift, steg- oder ringförmig ausgebildet. Somit kann ein Träger für den Kontaktbereich des Betätigungselements geschaffen werden.

Wenn der ortsfeste Kontaktbereich an einer schlitz- oder kreisförmigen Aufnahme angeordnet ist, kann diese mit dem oben beschriebenen Abschnitt des Betätigungselements zusammenwirken und in entsprechender Weise einen Träger für den ortsfesten Kontaktbereich bereitstellen.

Die Erfindung wird im Folgenden anhand mehrerer bevorzugter Ausführungsbeispiele unter Bezugnahme auf die folgende Beschreibung und die Zeichnung näher erläutert.

In der Zeichnung zeigen:
- Figur 1: einen Schnitt durch eine erste Ausführungsform einer erfindungsgemäßen Schaltereinheit in einem unbetätigten Zustand eines Betätigungselements;
- Figur 2: eine der Figur 1 entsprechende Ansicht in einem betätigten Zustand des Betätigungselements; und
- Figur 3: einen Schnitt durch eine zweite Ausführungsform einer erfindungsgemäßen Schaltereinheit.

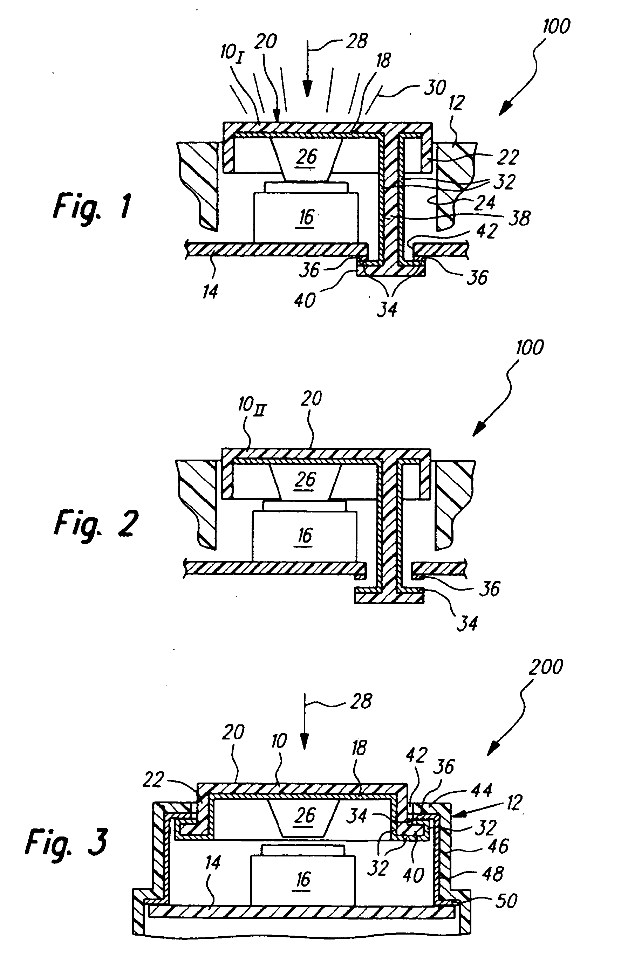

In den Figuren 1 bis 3 sind verschiedene erfindungsgemäße Schaltereinheiten 100 und 200 dargestellt, wobei sich entsprechende Bauteile mit gleichen Bezugszeichen versehen sind.

Die in Figur 1 im Schnitt dargestellte Schaltereinheit 100 umfasst ein Betätigungselement 10, das relativ zu einem ortsfesten Gehäuse 12 bewegbar ist. Die Schaltereinheit 100 umfasst ferner eine Leiterplatte oder Platine 14, auf der ein Schalter 16 angeordnet ist. An dem Betätigungselement 10 ist auf der dem Schalter 16 zugewandten Seite ein Näherungssensor 18 angeordnet.

Das Betätigungselement 10 weist eine Bedienfläche 20 auf, der sich eine Bedienperson mit einem Finger nähern kann. Die Bedienfläche ist an einem kreisförmigen Materialabschnitt des Betätigungselements 10 ausgebildet, der seitlich in einen zylindrischen Kragen 22 übergeht. Der Kragen 22 taucht in eine im Gehäuse 12 ausgebildete Führung 24. An dem Betätigungselement 10 ist, dem Schalter 16 zugewandt, ein Vorsprung 26 ausgebildet, mit dem der Schalter 16 bei Bewegung des Betätigungselements 10 in mit 28 bezeichneter Betätigungsrichtung betätigt werden kann.

Der Näherungssensor 18 umfasst einen flächigen Kondensatorabschnitt, der im Bereich der Bedienfläche 20 des Betätigungselements 14 ein elektrisches Feld erzeugt, das in Figur 1 mit dem Bezugszeichen 30 angedeutet ist. Das elektrische Feld 30 kann durch Annäherung eines Objekts an die Bedienfläche 20 oder bei Berührung der Bedienfläche 20 beeinflusst werden. Dies kann mit Hilfe einer nicht dargestellten Auswerteeinheit erfasst werden, um entsprechende Ausgangssignale zu erzeugen.

Der Näherungssensor 18 ist über parallel zur Betätigungsrichtung 28 verlaufende elektrische Leiter 32 mit elektrischen Kontaktbereichen 34 des Betätigungselements 10 verbunden. Die Kontaktbereiche 34 liegen in der in Figur 1 dargestellten Position des Betätigungselements an ortsfesten Kontaktbereichen 36 an, die an der Unterseite der Platine 14 ausgebildet sind.

Die elektrischen Leiter 32 sind an einem Steg 38 des Betätigungselements 10 angeordnet und sowohl einstückig mit dem Näherungssensor 18 als auch mit den Kontaktbereichen 34 ausgebildet. Die Kontaktbereiche 34 sind an einem sich im Wesentlichen quer zur Betätigungsrichtung 28 erstreckenden Materialabschnitt 40 des Betätigungselements 10 angeordnet, der eine in der Platine 14 ausgebildete, geschlitzte Aufnahme 42 hintergreift.

Bei Annäherung oder Berührung eines Objekts, beispielsweise eines Fingers einer Bedienperson, in Richtung auf die Bedienfläche 20, kann durch die Veränderung des elektrischen Feldes 30 mit Hilfe einer nicht dargestellten Auswerteeinheit ein entsprechendes Ausgangssignal erzeugt werden, um eine erste Schaltfunktion der Schaltereinheit 100 zu verwirklichen. Die elektrische Verbindung zwischen dem Näherungssensor 18 und der Auswerteeinheit wird dabei durch die sich berührenden Kontaktbereiche 34 und 36 geschaffen.

Wenn das Betätigungselement 10 aus der in Figur 1 dargestellten Lage I in die in Figur 2 dargestellte Lage II bewegt wird, indem beispielsweise ein Finger in mit 28 bezeichneter Richtung auf die Bedienfläche 20 drückt, wird die von den Kontaktbereichen 34 und 36 gebildete elektrische Kontaktierung des Näherungssensors 18 unterbrochen. Gleichzeitig kann mit Hilfe des Vorsprungs 26 der Schalter 16 betätigt werden, so dass eine zweite Schaltfunktion verwirklicht werden kann. Der Schalter 16 ist beispielsweise als Mikroschalter ausgebildet und erzeugt, wenn der Vorsprung 26 auf den Schalter 16 gedrückt wird, eine entgegengesetzte Rückstellkraft. Wenn die Bedienfläche 20 in der in Figur 2 dargestellten Lage II des Betätigungselements 10 losgelassen wird, bewirkt diese Rückstellkraft, dass das Betätigungselement 10 zurück in die in Figur 1 dargestellte Lage I geführt wird, wodurch die Kontaktbereiche 34 und 36 wieder in Anlage miteinander gebracht werden, so dass der Näherungssensor 18 wieder elektrisch kontaktiert ist.

Die in Figur 3 dargestellte Schaltereinheit 200 weist ebenfalls ein Betätigungselement 10 auf, das relativ zu einem Gehäuse 12 bewegbar ist. Der Näherungssensor 18 ist auf der der Bedienfläche 20 des Betätigungselements 10 abgewandten Seite angeordnet und weist in Richtung auf einen an der Platine 14 angeordneten Schalter 16, der mit einem Vorsprung 26 des Betätigungselements 10 betätigt werden kann.

Der Näherungssensor 18 ist über elektrische Leiter 32 mit einem Kontaktbereich 34 verbunden. Dabei bilden der Kontaktbereich 34 und die elektrischen Leiter 32 sowie der Näherungssensor 18 eine durchgehende Leiterbahn. Diese ist der Kontur des Betätigungselements 10 angepasst, das einen zylindrischen Kragen 22 sowie einen sich radial nach außen erstreckenden ringförmigen Abschnitt 40 aufweist. Der Abschnitt 40 hintergreift einen ringförmigen Gehäuseabschnitt 44, der auf der dem Abschnitt 40 zugewandten Seite einen ortsfesten Kontaktbereich 36 trägt. Der Abschnitt 44 des Gehäuses 12 geht in einen zylindrischen Abschnitt 46 über, der sich bis etwa zur Platine 14 hin erstreckt. Entlang des zylindrischen Abschnitts 46 sind elektrische Leiterabschnitte 48 und 50 vorgesehen, die einstückig mit dem Kontaktbereich 36 ausgebildet sind. Der elektrische Leiterabschnitt 50 ist in nicht näher dargestellter Weise elektrisch mit der Platine 14 verbunden.

Das Funktionsprinzip der Schaltereinheit 200 entspricht dem der Schaltereinheit 100. Durch entsprechende Betätigung des Betätigungselements 10 kann der Schalter 16 mit Hilfe des Vorsprungs 26 betätigt werden. Dabei können die Kontaktbereiche 34 und 36 voneinander beabstandet werden, sobald das Betätigungselement 10 aus der in Figur 3 dargestellten Ruhelage heraus bewegt wird. Dabei ist es zwar gewünscht, aber nicht erforderlich, dass mit Unterbrechung der Kontaktierung zwischen den Kontaktbereichen 34 und 36 gleichzeitig eine Betätigung des Schalters 16 erfolgt.

## Patentansprüche

1. Schaltereinheit (100, 200) mit einem durch Bewegung betätigbaren Betätigungselement (10) and mit einem Näherungssensor (18), wobei dem Betätigungselement (10) der elektrisch kontaktierte Näherungssensor (18) zugeordnet ist, **dadurch gekennzeichnet, dass** die elektrische Kontaktierung des Näherungssensors (18) in einem betätigten Zustand (II) des Betätigungselements (10) unterbrochen und in einem unbetätigten Zustand (I) des Betätigungselements geschlossen ist.

2. Schaltereinheit (100, 200) nach Anspruch 1, **dadurch gekennzeichnet, dass** die Schaltereinheit (100, 200) einen Schalter (16) umfasst, der von dem Betätigungselement (10) betätigbar ist und eine Rückstellkraft erzeugt, die die elektrische Kontaktierung schließt und/oder in einem geschlossenen Zustand hält.

3. Schaltereinheit (100, 200) nach Anspruch 1 oder 2, **dadurch gekennzeichnet, dass** der Schalter (16) durch eine Hub-, Dreh-, Schiebe- und/oder Kippbewegung des Betätigungselements (10) betätigbar ist.

4. Schaltereinheit (100, 200) nach mindestens einem der vorhergehenden Ansprüche, **dadurch gekennzeichnet, dass** das Betätigungselement (10) durch Betätigung elastisch verformbar ist und eine Rückstellkraft erzeugt, die die elektrische Kontaktierung schließt und/oder in einem geschlossenen Zustand hält.

5. Schaltereinheit (100, 200) nach mindestens einem der vorhergehenden Ansprüche, **dadurch gekennzeichnet, dass** die Schaltereinheit (100, 200) ein separates, insbesondere als Feder ausgebildetes elastisches Element umfasst, das eine Rückstellkraft erzeugt, die die elektrische Kontaktierung schließt und/oder in einem geschlossenen Zustand hält.

6. Schaltereinheit (100, 200) nach mindestens einem der vorhergehenden Ansprüche, **dadurch gekennzeichnet, dass** die elektrische Kontaktierung einen Kontaktbereich (34) aufweist, der dem Betätigungselement (10) zugeordnet ist und einen relativ zu dem Betätigungselement (10) ortsfesten Kontaktbereich (36) .

7. Schaltereinheit (100, 200) nach Anspruch 6, **dadurch gekennzeichnet, dass** der dem Betätigungselement (10) zugeordnete Kontaktbereich (34) elektrisch mit dem Näherungssensor (18) verbunden und/oder einstückig mit diesem ausgebildet ist.

8. Schaltereinheit (100, 200) nach Anspruch 6 oder 7, **dadurch gekennzeichnet, dass** der ortsfeste Kontaktbereich (36) elektrisch mit einer Auswerteeinheit für den Näherungssensor (18) und/oder mit einer Platine (14) der Schaltereinheit (100, 200) verbunden ist.

9. Schaltereinheit (100, 200) nach mindestens einem Ansprüche 6 bis 8, **dadurch gekennzeichnet, dass** der ortsfeste Kontaktbereich (36) an einem Gehäuse (12) der Schaltereinheit (100, 200) angeordnet ist.

10. Schaltereinheit (100, 200) nach mindestens einem der Ansprüche 6 bis 9, **dadurch gekennzeichnet, dass** das Gehäuse (12) einen elektrischen Leiter (48, 50) aufweist, der den ortsfesten Kontaktbereich (36) mit der Auswerteeinheit für den Näherungssensor (18) und/oder mit der Platine (14) der Schaltereinheit (100, 200) elektrisch verbindet.

11. Schaltereinheit (100, 200) nach mindestens einem der Ansprüche 6 bis 10, **dadurch gekennzeichnet, dass** der ortsfeste Kontaktbereich (36) an der Platine (14) der Schaltereinheit (100, 200) angeordnet ist.

12. Schaltereinheit (100, 200) nach mindestens einem der Ansprüche 6 bis 11, **dadurch gekennzeichnet, dass** der Kontaktbereich (34) des Betätigungselements (10) an einem Abschnitt (40) des Betätigungselements (10) angeordnet ist, der den ortsfesten Kontaktbereich (36) hintergreift.

13. Schaltereinheit (100, 200) nach Anspruch 13, **dadurch gekennzeichnet, dass** der Abschnitt (40) des Betätigungselements (10) steg- oder ringförmig ausgebildet ist.

14. Schaltereinheit (100, 200) nach Anspruch 13 oder 14, **dadurch gekennzeichnet, dass** der ortsfeste Kontaktbereich (36) an einer schlitz- oder kreisförmigen Aufnahme 42) angeordnet ist.

## Claims

1. Switch unit (100, 200) having an operating element (10), which can be operated by movement, and having a proximity sensor (18), wherein the electrically contact-connected proximity sensor (18) is associated with the operating element (10), **characterized in that** the electrical contact-connection of the proximity sensor (18) is interrupted in an operated state (II) of the operating element (10), and is closed in an unoperated state (I) of the operating element.

2. Switch unit (100, 200) according to Claim 1, **characterized in that** the switch unit (100, 200) comprises a switch (16) which can be operated by the operating element (10) and generates a restoring force which closes the electrical contact-connection and/or holds the said electrical contact-connection in a closed state.

3. Switch unit (100, 200) according to Claim 1 or 2, **characterized in that** the switch (16) can be operated by a lifting, rotary, sliding and/or tilting movement of the operating element (10).

4. Switch unit (100, 200) according to at least one of the preceding claims, **characterized in that** the operating element (10) can be elastically deformed by operation and generates a restoring force which closes the electrical contact-connection and/or holds the said electrical contact-connection in a closed state.

5. Switch unit (100, 200) according to at least one of the preceding claims, **characterized in that** the switch unit (100, 200) comprises a separate elastic element, which is in particular in the form of a spring, which generates a restoring force which closes the electrical contact-connection and/or holds the said electrical contact-connection in a closed state.

6. Switch unit (100, 200) according to at least one of the preceding claims, **characterized in that** the electrical contact-connection has a contact region (34) which is associated with the operating element (10) and a contact region (36) which is stationary in relation to the operating element (10).

7. Switch unit (100, 200) according to Claim 6, **characterized in that** the contact region (34) which is associated with the operating element (10) is electrically connected to the proximity sensor (18) and/or is integrally formed with the said proximity sensor.

8. Switch unit (100, 200) according to Claim 6 or 7, **characterized in that** the stationary contact region (36) is electrically connected to an evaluation unit for the proximity sensor (18) and/or to a printed circuit board (14) of the switch unit (100, 200).

9. Switch unit (100, 200) according to at least one of Claims 6 to 8, **characterized in that** the stationary contact region (36) is arranged on a housing (12) of the switch unit (100, 200).

10. Switch unit (100, 200) according to at least one of Claims 6 to 9, **characterized in that** the housing (12) has an electrical conductor (48, 50) which electrically connects the stationary contact region (36) to the evaluation unit for the proximity sensor (18) and/or to the printed circuit board (14) of the switch unit (100, 200).

11. Switch unit (100, 200) according to at least one of Claims 6 to 10, **characterized in that** the stationary contact region (36) is arranged on the printed circuit board (14) of the switch unit (100, 200).

12. Switch unit (100, 200) according to at least one of Claims 6 to 11, **characterized in that** the contact region (34) of the operating element (10) is arranged on a portion (40) of the operating element (10) which engages behind the stationary contact region (36).

13. Switch unit (100, 200) according to Claim 13, **characterized in that** the portion (40) of the operating element (10) is of web- or ring-like design.

14. Switch unit (100, 200) according to Claim 13 or 14, **characterized in that** the stationary contact region (36) is arranged on a slot- or circle-like holder (42).

## Revendications

1. Bloc de commutateur (100, 200) comprenant un élément d'actionnement (10) pouvant être actionné par un mouvement et comprenant un détecteur de proximité (18), le détecteur de proximité (18) à contact électrique étant associé à l'élément d'actionnement (10), **caractérisé en ce que** le contact électrique du détecteur de proximité (18) est interrompu dans un état actionné (II) de l'élément d'actionnement (10) et fermé dans un état non actionné (I) de l'élément d'actionnement.

2. Bloc de commutateur (100, 200) selon la revendication 1, **caractérisé en ce que** le bloc de commutateur (100, 200) comprend un commutateur (16) qui peut être actionné par l'élément d'actionnement (10) et génère une force de rappel qui ferme le contact électrique et/ou le maintient dans une position fermée.

3. Bloc de commutateur (100, 200) selon la revendication 1 ou 2, **caractérisé en ce que** le commutateur (16) peut être actionné par un mouvement de levage, de rotation, de coulissement et/ou de basculement de l'élément d'actionnement (10).

4. Bloc de commutateur (100, 200) selon au moins l'une des revendications précédentes, **caractérisé en ce que** l'élément d'actionnement (10) est déformable par effet élastique lorsqu'il est actionné et génère une force de rappel qui ferme le contact électrique et/ou le maintient dans une position fermée.

5. Bloc de commutateur (100, 200) selon au moins l'une des revendications précédentes, **caractérisé en ce que** le bloc de commutateur (100, 200) comprend un élément séparé, notamment souple réalisé sous la forme d'un ressort, lequel génère une force de rappel qui ferme le contact électrique et/ou le maintient dans une position fermée.

6. Bloc de commutateur (100, 200) selon au moins l'une des revendications précédentes, **caractérisé en ce que** le contact électrique présente une zone de contact (34) qui est associée à l'élément d'actionnement (10) et une zone de contact (36) qui est fixe par rapport à l'élément d'actionnement (10).

7. Bloc de commutateur (100, 200) selon la revendication 6, **caractérisé en ce que** la zone de contact (34) associée à l'élément d'actionnement (10) est reliée électriquement avec le détecteur de proximité (18) et/ou est réalisée d'une seule pièce avec celui-ci.

8. Bloc de commutateur (100, 200) selon la revendication 6 ou 7, **caractérisé en ce que** la zone de contact fixe (36) est reliée électriquement avec une unité d'interprétation pour le détecteur de proximité (18) et/ou avec une platine (14) du bloc de commutateur (100, 200).

9. Bloc de commutateur (100, 200) selon au moins l'une des revendications 6 à 8, **caractérisé en ce que** la zone de contact fixe (36) est disposée sur un boîtier (12) du bloc de commutateur (100, 200).

10. Bloc de commutateur (100, 200) selon au moins l'une des revendications 6 à 9, **caractérisé en ce que** le boîtier (12) présente un conducteur électrique (48, 50) qui relie électriquement la zone de contact fixe (36) avec l'unité d'interprétation pour le détecteur de proximité (18) et/ou avec la platine (14) du bloc de commutateur (100, 200).

11. Bloc de commutateur (100, 200) selon au moins l'une des revendications 6 à 10, **caractérisé en ce que** la zone de contact fixe (36) est disposée sur la platine (14) du bloc de commutateur (100, 200).

12. Bloc de commutateur (100, 200) selon au moins l'une des revendications 6 à 11, **caractérisé en ce que** la zone de contact (34) de l'élément d'actionnement (10) est disposée sur une section (40) de l'élément d'actionnement (10) en prise par l'arrière avec la zone de contact fixe (36).

13. Bloc de commutateur (100, 200) selon la revendication 13, **caractérisé en ce que** la section (40) de l'élément d'actionnement (10) est réalisée en forme de nervure ou d'anneau.

14. Bloc de commutateur (100, 200) selon la revendication 13 ou 14, **caractérisé en ce que** la zone de contact fixe (36) est disposée sur un logement (42) en forme de fente ou de croix.
